# EUROPÄISCHE PATENTSCHRIFT

(11) **EP 4 073 837 B1**
(45) Veröffentlichungstag und Bekanntmachung des Hinweises auf die Patenterteilung: **27.12.2023**
(21) Anmeldenummer: 21704424.7
(22) Anmeldetag: 28.01.2021
(51) Int. Cl.: H01L 23/373, H01L 21/48

(54) **ELEKTRONIKMODUL, VERFAHREN ZUR HERSTELLUNG EINES ELEKTRONIKMODULS UND INDUSTRIEANLAGE**
ELECTRONIC MODULE, METHOD FOR PRODUCING AN ELECTRONIC MODULE, AND INDUSTRIAL PLANT
MODULE ÉLECTRONIQUE, PROCÉDÉ DE PRODUCTION DE MODULE ÉLECTRONIQUE ET INSTALLATION INDUSTRIELLE

(30) Priorität: 28.02.2020 DE 102020202607; 25.06.2020 EP 20182203
(43) Veröffentlichungstag der Anmeldung: 19.10.2022
(73) Patentinhaber: Siemens Aktiengesellschaft, 80333 München (DE)
(72) Erfinder: BAUEREGGER, Hubert, 86438 Kissing (DE); DONAT, Albrecht, 91462 Dachsbach (DE); GANSTER, Axel, 84419 Schwindegg (DE); LAMBRECHT, Franziska, 90607 Rückersdorf (DE); LASCH, Markus, 81927 München (DE); STEGMEIER, Stefan, 81825 München (DE); WEISBROD, Erik, 81369 München (DE); ZAPF, Jörg, 81927 München (DE)
(74) Vertreter: Siemens Patent Attorneys
(86) Internationale Anmeldenummer: PCT/EP2021/051899
(87) Internationale Veröffentlichungsnummer: WO 2021/170332

(56) Entgegenhaltungen:
- WO-A1-2009/134448
- DE-A1-102009 033 029
- US-A- 5 672 848
- US-A1- 2006 258 055
- US-A1- 2012 074 568
- ELAKKIYA R ET AL: "Reliability Enhancement of a Power Semiconductor With Optimized Solder Layer Thickness", IEEE TRANSACTIONS ON POWER ELECTRONICS, INSTITUTE OF ELECTRICAL AND ELECTRONICS ENGINEERS, USA, Bd. 35, Nr. 6, 6. November 2019 (2019-11-06), Seiten 6397-6404, XP011774628, ISSN: 0885-8993, DOI: 10.1109/TPEL.2019.2951815 [gefunden am 2020-02-25]

## Beschreibung

Die Erfindung betrifft ein Elektronikmodul, ein Verfahren zur Herstellung eines Elektronikmoduls und eine Industrieanlage.

Industrieanlagen mit Motoren oder Generatoren umfassen zumeist Steuereinrichtungen zur Steuerung der Motoren oder Generatoren. Solche Steuereinrichtungen weisen regelmäßig Elektronikmodule in Form von Leistungsmodulen auf, welche einen Teil der Steuerelektronik solcher Steuereinrichtungen enthalten.

Bei solchen Elektronikmodulen sind regelmäßig Halbleiterelemente wie IGBTs oder MOSFETs oder FJETs oder Dioden oder Halbleiterchips mit einem oder mehreren der vorgenannten Bauteile auf organischen oder keramischen Schaltungsträgern aufgebracht, etwa Schaltungsträgern in Form von PCBs (engl.: "*Printed Circuit Boards*") oder DBC-Substraten (engl.: "*direct copper bonded*") oder AMB-Substraten (engl.: "*active metal brazed*") *.*

Die Halbleiterelemente sind miteinander über elektrische Leiterbahnen, welche etwa mit Kupfer und/oder Aluminium gebildet sind, elektrisch verbunden. Jedoch unterscheiden sich die Wärmeausdehnungskoeffizienten der elektrischen Leiterbahnen von den Wärmeausdehnungskoeffizienten des Materials der Schaltungsträger regelmäßig um Größenordnungen. Daher verursachen thermische Lastwechsel hohe mechanische Spannungen in der Grenzschicht zwischen Leiterbahn und Schaltungsträger, sodass Delamination oder Muschelbrüche resultieren. Daher weisen Leiterbahnen bei Leistungsmodulen typisch Leiterbahndicken bis maximal 0,8 mm auf.

Ein Ansatz mit dickeren Leiterbahnen ist beispielsweise aus der DE 10 2009 033 029 A1 bekannt. Diese offenbart ein elektronisches Leistungsmodul welches durch zwei Metallisierungsbereiche auf eine wesentlich größere Gesamtschichtdicke an elektrisch leitendem und Wärme abführenden Materials aufweist.

Als Alternative sind Dickkupfer-Substrate mit speziellen kräfteaufnehmenden Isolationsmaterialien (Polyimide) oder Niedrig-Ausdehnungs-Materialien (mit keramischen Partikeln versetzter Epoxy) bekannt, sodass auch Kupferdicken von mehr als 2 Millimetern realisiert werden können. Mittels solcher Dickkupfer-Substrate mit den genannten Kupferdicken lässt sich eine hohe Wärmespreizung und folglich eine hohe Robustheit gegenüber Lastwechseln realisieren.

Um eine Metall-Strukturierung zu realisieren, wird das Metall gefräst oder geätzt. Allerdings ist dies zeitaufwändig und teuer.

So werden Dickkupfer-Substrate beim Ätzen mittels fotostrukturierbarer Lacke oder Folien strukturiert. Dabei kann ein Ätzmedium nur an geöffneten Stellen der Lacke oder Folien angreifen und das Dickkupfer ätzen. Nachteilig sind jedoch die langen Ätzzeiten von vielen Minuten bis Stunden, um mehrere Millimeter Metall zu ätzen. Zudem ergeben sich Ätzhinterschnitte, welche im Betrieb zu lokalen Potentialerhöhungen und dadurch bedingt zu elektrischen Durchbrüchen führen können. Für sehr dicke Metallschichten von mehr als einem Millimeter ist Ätzen daher nicht rentabel. Zudem ist bei nasschemischem Ätzen die erforderliche Sicherheit nur aufwendig zu gewährleisten.

Um Ätzzeiten zu beschleunigen und andererseits die Ätzhinterschnitte zu vermeiden kann eine Vorstrukturierung mittels Fräsens erfolgen: Beispielsweise werden von einer zwei Millimeter dicken zu entfernenden Kupferschicht 1,9 Millimeter mittels Fräsens abgetragen und nur die restlichen 0,1 mm mittels Ätzens entfernt. Allerdings bedeutet auch die Verwendung von verschiedenen Prozessverfahren zur Herstellung des Substrates eine verlängerte Herstellungszeit, welche sich aufgrund zusätzlich erforderlicher Reinigungsschritte nach dem Fräsen, etwa zur Entfernung von Öl oder Partikeln, weiter verlängert.

Folglich ist es eine Aufgabe der Erfindung, verbesserte Elektronikmodule mit Dickschicht-Substraten anzugeben, welche insbesondere einfach und kostengünstig herstellbar sind und welche vorzugsweise leicht hinsichtlich einer Strukturierung anpassbar sind. Weiterhin ist es Aufgabe der Erfindung, ein verbessertes Verfahren zur Herstellung eines solchen Elektronikmoduls anzugeben. Zudem ist es eine Aufgabe der Erfindung, eine verbesserte Industrieanlage mit mindestens einem solchen Elektronikmodul zu schaffen.

Diese Aufgabe der Erfindung wird mit einem Elektronikmodul mit den in Anspruch 1 angegebenen Merkmalen und mit einem Verfahren zur Herstellung eines solchen Elektronikmoduls mit den in Anspruch 9 angegebenen Merkmalen sowie mit einer Industrieanlage mit den in Anspruch 10 angegebenen Merkmalen gelöst. Bevorzugte Weiterbildungen der Erfindung sind in den zugehörigen Unteransprüchen, der nachfolgenden Beschreibung und der Zeichnung angegeben.

Das erfindungsgemäße Elektronikmodul ist insbesondere ein Leistungsmodul und weist einen Schaltungsträger auf, welcher mindestens eine thermisch leitende Dickschicht mit mindestens einer Dicke von zumindest 0,5 Millimetern, vorzugsweise mindestens 2 Millimetern und idealerweise mindestens 4 Millimetern, aufweist. Die thermisch leitende Dickschicht weist erfindungsgemäß eine Mehrzahl von miteinander verbundenen, thermisch leitfähiger Elementen auf, welche mittels eines thermisch leitfähigen Materials, vorzugsweise stoffschlüssig, miteinander verbunden sind. Bei dem erfindungsgemäßen Elektronikmodul weisen die thermisch leitfähigen Elemente je eine Grundfläche mit dreizähliger und/oder vierzähliger und/oder sechszähliger Symmetrie auf.

Dadurch lässt sich eine Dickschicht in ihren flächigen Erstreckungsrichtungen, d.h. in Richtungen quer, insbesondere senkrecht, zur Dicke der Dickschicht, beliebig ausgedehnt und lückenlos parkettieren.

Die Dickschicht des erfindungsgemäßen Elektronikmoduls mit der Dicke von zumindest 0,5 Millimetern erlaubt eine effiziente Entwärmung von wärmeabgebenden elektrischen Bauteilen, insbesondere Leistungsbauteilen. Infolge der Dicke der Dickschicht ist eine laterale Wärmeleitfähigkeit und folglich eine hohe Wärmespreizung möglich. Vorteilhaft erlaubt eine Realisierung der Dickschicht mittels thermisch leitfähiger Elemente einen besonders flexiblen Aufbau einer Dickschicht eines Elektronikmoduls. Im Gegensatz zu mit Ätztechnik gefertigten Dickschichten lässt sich die Dickschicht des erfindungsgemäßen Elektronikmoduls hinterschnittfrei fertigen.

Unter thermisch leitfähigen Elementen im Sinne dieser Erfindung sind Elemente zu verstehen, deren Material bei Normaldruck und Raumtemperatur eine thermische Leitfähigkeit vom mindestens 1 W/mK aufweist, vorzugsweise zumindest 8 W/mK und idealerweise zumindest 15 W/mK. Unter einem thermisch leitfähigen Material im Sinne dieser Erfindung ist ein Material zu verstehen, welches bei Normaldruck und Raumdruck eine thermische Leitfähigkeit von mindestens 1 W/mK aufweist, vorzugsweise zumindest 8 W/mK und idealerweise zumindest 15 W/mK.

Idealerweise sind die thermisch leitfähigen Elemente bei dem erfindungsgemäßen Elektronikmodul zudem elektrisch leitfähige Elemente. Bevorzugt ist das thermisch leitfähige Material elektrisch leitfähiges Material. Unter elektrisch leitfähig wird ein Element oder Material im Sinne dieser Erfindung dann verstanden, wenn die elektrische Leitfähigkeit bei Normaldruck und Raumtemperatur mindestens 10⁴ S/m, vorzugsweise mindestens 10⁵ S/m und idealerweise mindestens 10⁶ S/m beträgt. Bei einer Vielzahl von Materialien geht eine hohe thermische Leitfähigkeit mit einer hohen elektrischen Leitfähigkeit einher, sodass eine hohe elektrische Leitfähigkeit regelmäßig eine hohe thermische Leitfähigkeit bedingt.

Bei dem erfindungsgemäßen Leistungsmodul wird der Wärmepfad zwischen den thermisch leitfähigen Elementen vorteilhaft mit dem thermisch leitfähigen Material geschlossen. Es zeigt sich, dass der Schaltungsträger insbesondere im Falle elektrisch leitfähiger Elemente aus Kupfer und insbesondere bei einer Dicke des thermisch leitfähigen Materials zwischen den thermisch leitfähigen Elementen von 20 µm und vorzugsweise einer Wärmeleitfähigkeit des thermisch leitfähigen Materials von 40 W/mK nahezu gleiche Gesamtwärmeeigenschaften aufweist wie eine gleichartig dimensionierte und aus einem einzigen Block gefertigte Dickschicht.

Vorzugsweise sind bei dem erfindungsgemäßen Elektronikmodul die thermisch leitfähigen Elemente mittels eines thermisch leitfähigen Materials in Gestalt eines Klebers und/oder eines Lots miteinander verbunden und/oder die leitfähigen Elemente sind mittels einer Sinterverbindung miteinander verbunden. Mittels der vorgenannten Alternativen lässt sich eine stoffschlüssige Verbindung der thermisch leitfähigen Elemente einfach und kostengünstig erreichen.

Bei dem erfindungsgemäßen Elektronikmodul weist das thermisch leitfähige Material bevorzugt eine Wärmeleitfähigkeit von mindestens 20 mW/mK, vorzugsweise von mindestens 30 W/mK und idealerweise von zumindest 35 W/mK auf. Mit einer solchen thermischen Leitfähigkeit weist die mit diesem thermisch leitfähigen Material gebildete Dickschicht im Falle insbesondere von thermisch leitfähigen Elementen in Gestalt von Metallelementen vergleichbare Wärmespreizeigenschaften auf wie eine gleichartig dimensionierte und aus einem einzigen Block gefertigte Dickschicht.

Bei dem Elektronikmodul gemäß der Erfindung weist das thermisch leitfähige Material eine Dicke von höchstens 100 Mikrometern, vorzugsweise höchstens 50 Mikrometern, idealerweise höchstens 30 Mikrometern, auf.

In einer vorteilhaften Weiterbildung der Erfindung weist bei dem Elektronikmodul die Dickschicht eine Oberfläche auf und die thermisch leitfähigen Elemente bilden die Oberfläche nicht-plan, vorzugsweise gestuft und/oder strukturiert. Auf diese Weise können Erfordernisse einer elektrischen Schaltung, welche der Schaltungsträger trägt, bereits bei der Anordnung der thermisch leitfähigen Elemente berücksichtigt werden. Auf diese Weise ist eine nachträgliche aufwendige subtraktive Bearbeitung der Dickschicht verzichtbar, da die räumlichen Erfordernisse bereits bei der Herstellung der Dickschicht selbst berücksichtigt wurden.

Zweckmäßig sind bei dem erfindungsgemäßen Elektronikmodul die thermisch leitfähigen Elemente mit einem anderen als dem thermisch leitfähigen Material gebildet. Auf diese Weise ist bei dem erfindungsgemäßen Elektronikmodul die Dickschicht hinsichtlich ihres Materials heterogen ausgebildet. Auf diese Weise kann etwa das elektrisch leitfähige Material hinsichtlich besonders guter stoffschlüssiger Verbindungseigenschaften, hinsichtlich prozesstechnischer Handhabbarkeit oder Prozessflexibilität oder Prozessgenauigkeit ausgewählt werden, während die Elemente, welche vorzugsweise den überwiegenden Volumenanteil der Dickschicht bilden, etwa allein hinsichtlich der thermischen Eigenschaften oder hinsichtlich der Materialkosten ausgewählt werden können.

Bei dem erfindungsgemäßen Elektronikmodul sind die thermisch leitfähigen Elemente vorzugsweise mit einem Metall, insbesondere Kupfer und/oder Aluminium und/oder Molybdän, und/oder einem Nichtmetall, insbesondere einem thermisch leitfähigen Polymer, gebildet. Solche thermisch leitfähigen Elemente sind kostengünstig und einfach fertigbar, sodass das erfindungsgemäße Elektronikmodul einfach und günstig herstellbar ist.

Vorzugsweise weisen bei dem erfindungsgemäßen Elektronikmodul gemäß der Erfindung die thermisch leitfähigen Elemente je eine dreieckige und/oder viereckige und/oder sechseckige Grundfläche auf. Auf diese Weise lassen sich insbesondere Kanten der Dickschicht leicht realisieren.

Besonders bevorzugt weist das erfindungsgemäße Elektronikmodul thermisch leitfähige Elemente auf, welche nicht lediglich eine einzige der vorgenannten Grundflächen aufweisen. Auf diese Weise lassen sich die thermisch leitfähigen Elemente räumlich derart zueinander anordnen, dass vorgegebene geometrische Erfordernisse der Dickschicht des erfindungsgemäßen Elektronikmoduls ohne eine subtraktive Nachbearbeitung der Dickschicht realisieren lassen.

Bei dem erfindungsgemäßen Verfahren zur Herstellung eines erfindungsgemäßen Elektronikmoduls wie oben beschrieben werden die elektrisch leitfähigen Elemente angeordnet und mittels des elektrisch leitfähigen Materials miteinander verbunden. Mittels des erfindungsgemäßen Verfahrens ergeben sich die bereits zu dem erfindungsgemäßen Elektronikmodul näher erläuterten Vorteile. Erfindungsgemäß werden thermisch leitfähige Elemente herangezogen, welche mit thermisch leitfähigem Material in Gestalt eines Lots beschichtet sind, wobei die thermisch leitfähigen Elemente angeordnet werden und nachfolgend das thermisch leitfähige Material umgeschmolzen wird. Dadurch kann das thermisch leitfähige Material besonders einfach zwischen die thermisch leitfähigen Elemente eingebracht werden.

Insbesondere lässt sich mittels des erfindungsgemäßen Verfahrens ein Elektronikmodul besonders einfach und kostengünstig herstellen.

Bevorzugt werden die thermisch leitfähigen Elemente bereitgestellt, indem diese, vorzugsweise mittels Sägen und/oder Stanztechnik und/oder Schneidverfahren, insbesondere Laserschneiden und/oder Wasserstrahlschneiden, subtraktiv gefertigt werden. Bei den genannten subtraktiven Fertigungsverfahren handelt es sich vorteilhaft um etablierte Fertigungsverfahren, mittels welchen die thermisch leitfähigen Elemente mit leicht planbaren Kosten und/oder Toleranzen und/oder Zeitaufwänden hergestellt werden können.

Die erfindungsgemäße Industrieanlage weist eine Steuereinrichtung, insbesondere zur Steuerung eines Motors und/oder Generators vorzugsweise der Industrieanlage, auf. Die Steuereinrichtung der erfindungsgemäßen Industrieanlage umfasst mindestens ein erfindungsgemäßes Elektronikmodul wie oben beschrieben. Infolge der erfindungsgemäß besonders leichten Fertigbarkeit des erfindungsgemäßen Elektronikmoduls lässt sich die erfindungsgemäße Industrieanlage ebenfalls leicht herstellen. Vorteilhafterweise eröffnet die erfindungsgemäß gegenüber dem Stand der Technik deutlich erleichterte Fertigbarkeit der Dickschicht des erfindungsgemäßen Elektronikmoduls vorteilhaft eine kostengünstige Anpassbarkeit der Industrieanlage an geometrische Erfordernisse der elektrischen Schaltung.

Nachfolgend wird die Erfindung anhand eines in der Zeichnung dargestellten Ausführungsbeispiels näher erläutert. Es zeigen:
- Fig. 1: eine erfindungsgemäße Industrieanlage mit einem Motor und einer Motorsteuerung mit einem Leistungsmodul schematisch in einer Prinzipskizze sowie

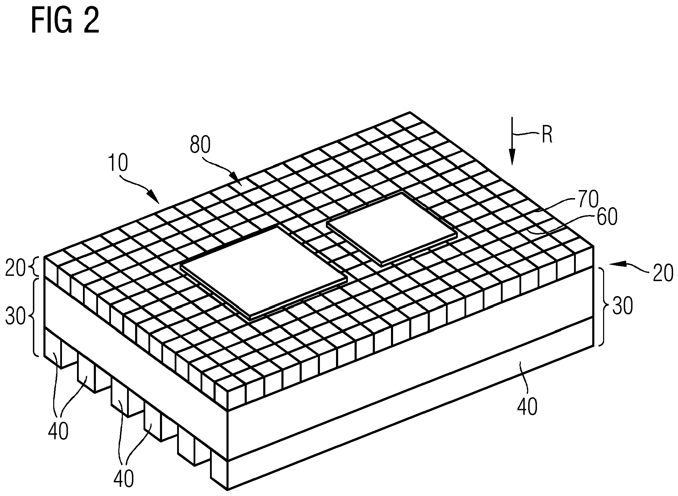

- Fig. 2: das erfindungsgemäße Elektronikmodul schematisch in einer perspektivischen Darstellung.

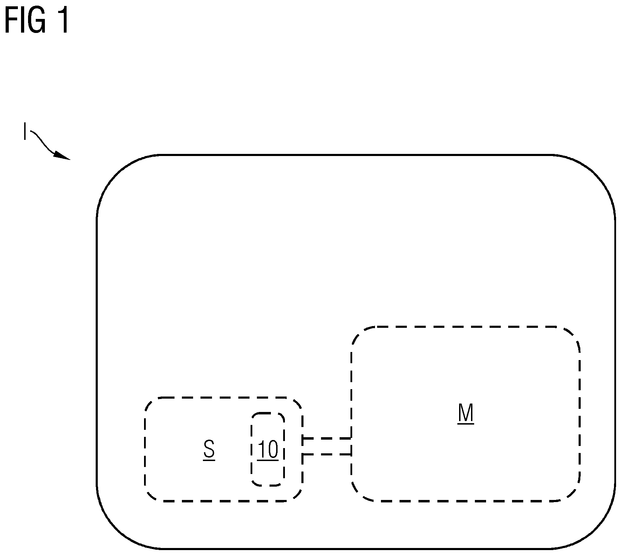

Die in Fig. 1 schematisch dargestellte erfindungsgemäße Industrieanlage I ist ein Industriemotor, welche eine elektrische Maschine M in Gestalt eines Elektromotors sowie eine Motorsteuerung S umfasst. Die Motorsteuerung S weist ein erfindungsgemäßes Elektronikmodul 10 in Gestalt eines Leistungsmoduls auf. Grundsätzlich kann in weiteren, nicht eigens dargestellten Ausführungsbeispielen die Industrieanlage I eine sonstige Industrieanlage mit zumindest einem erfindungsgemäßen Elektronikmodul 10 sein.

Das erfindungsgemäße Elektronikmodul 10 umfasst ein als im Wesentlichen quaderförmiges Flachteil ausgebildetes Dickschicht-Substrat 20, welches mit einer seiner beiden Flachseiten an einem Kühlkörper 30 angebunden ist. Der Kühlkörper 30 weist an seiner dem Dickschicht-Substrat 20 abgewandten Seite Kühllamellen 40 auf. An seiner dem Kühlkörper 30 abgewandten Flachseite sind an dem Dickschicht-Substrat 20 Leistungshalbleiter in Gestalt von IGBT-Transistoren (IGBT = engl. "Insulated Gate Bipolar Transistor") angeordnet.

Das Dickschicht-Substrat 20 ist im dargestellten Ausführungsbeispiel mit einem Massenanteil von mehr als 50 Prozent, im dargestellten Ausführungsbeispiel von mehr als 98 Prozent, mit Metall, hier Kupfer, gebildet.

Das Dickschicht-Substrat 20 ist mit einzelnen Metallelementen 60, im dargestellten Ausführungsbeispiel Kupferelementen, gebildet. Dazu sind die Metallelemente 60 in Richtungen senkrecht zur geringsten Ausdehnung R des Dickschicht-Substrats 20, also in flächigen Richtungen des Dickschicht-Substrats 20, einander benachbart angeordnet. Die Metallelemente 60 weisen im dargestellten Ausführungsbeispiel eine quaderförmige Gestalt, hier speziell eine würfelförmige Gestalt, auf. Die Metallelemente 60 sind mit einem thermisch leitfähigen Lot 70 an denjenigen Seitenflächen, welche einander in flächigen Richtungen des Dickkupfer-Substrats 20 zugewandt sind, aneinander stoffschlüssig angebunden. Dazu ist das Lot 70 im dargestellten Ausführungsbeispiel mit einer Dicke zwischen den Metallelementen 60, also einer Dicke in flächigen Richtungen des Dickschicht-Substrats 20, von 20 Mikrometern befindlich. In weiteren, nicht eigens dargestellten Ausführungsbeispielen kann die Dicke auch abweichen und weist bevorzugt eine Dicke von höchsten 100 Mikrometern auf, beispielsweise 80 Mikrometer oder 40 Mikrometer. Das Lot 70 ist im dargestellten Ausführungsbeispiel mit einem Metall gebildet, welches einen niedrigeren Schmelzpunkt aufweist als jener des Metalls der Metallelemente 60, im gezeigten Ausführungsbeispiel mit Zinn, wobei grundsätzlich auch andere Lote 70 in Betracht kommen.

In weiteren, nicht eigens dargestellten Ausführungsbeispielen können an die Stelle der mit Kupfer gebildeten Metallelemente 60 auch mit einem anderen Metall, etwa mit Aluminium und/oder mit Molybdän, gebildete Metallelemente 60 treten. Zudem können in weiteren Ausführungsbeispielen an die Stelle der thermisch leitfähigen Metallelemente 60 thermisch leitfähige Polymerelemente aus einem thermisch leitfähigen Polymer treten. Im Übrigen entsprechen diese weiteren Ausführungsbeispiele dem dargestellten Ausführungsbeispiel.

Anstelle oder zusätzlich zu einer Lotverbindung der Metallelemente 60 miteinander kann in weiteren, nicht eigens dargestellten Ausführungsbeispielen eine stoffschlüssige Verbindung der Metallelemente 60 miteinander mittels eines thermisch leitfähigen Klebers und/oder mittels einer Sinterverbindung bestehen.

Im dargestellten Ausführungsbeispiel weist das Lot 70 eine Wärmeleitfähigkeit von mindestens 20 W/mK auf. In weiteren nicht eigens gezeigten Ausführungsbeispielen kann die Wärmeleitfähigkeit 30 W/mK oder 35 W/mK betragen. Dieselben Werte gelten in den oben erwähnten Ausführungsbeispielen für die Wärmeleitfähigkeit des Klebers oder der Sinterverbindung.

Im dargestellten Ausführungsbeispiel sind die Metallelemente 60 derart angeordnet, dass die Metallelemente 60 eine in einer gemeinsamen Ebene miteinander bündig abschließende Oberfläche bilden. Dies ist jedoch nicht notwendigerweise erforderlich: In weiteren, nicht eigens dargestellten Ausführungsbeispielen sind die Metallelemente 60 in Dickenrichtung des Dickschicht-Substrats 20, also in Richtung R der geringsten Dicke des Dickschicht-Substrats 20, gegeneinander versetzt oder mit einer voneinander abweichenden Dicke ausgebildet, sodass das Dickschicht-Substrat 20 eine gestufte Oberfläche fern dem Kühlkörper 30 aufweist, wobei einzelne Metallelemente 60 Stufen der gestuften Oberfläche bilden.

Im dargestellten Ausführungsbeispiel weisen die Metallelemente 60 infolge ihrer Würfelform eine vierzählige Drehsymmetrie auf. In weiteren, nicht eigens dargestellten Ausführungsbeispielen weisen die Metallelemente 60 eine zweizählige Symmetrie und/oder eine dreizählige und/oder sechszählige Symmetrie auf. Dabei weisen die Metallelemente 60 insbesondere eine Grundfläche 80, d.h. eine quer, insbesondere senkrecht, zur Richtung R der Dicke des Dickschicht-Substrats 20 orientierte Fläche beispielsweise mit viereckiger und/oder dreieckiger und/oder sechseckiger Gestalt auf.

Im dargestellten Ausführungsbeispiel bilden Quadrate die Grundfläche 80 der Metallelemente 60.

Das erfindungsgemäße Elektronikmodul 10 ist erfindungsgemäß wie folgt fertigbar:
Zunächst werden die Metallelemente 60 aus Volumenmaterial, hier einem Kupferblock, subtraktiv gefertigt, beispielsweiseweise mittels Sägen, mittels einer Stanztechnik oder mittels Schneidverfahren wie Laserschneiden oder Wasserstrahlschneiden. Nachfolgend werden die Metallelemente 60 angeordnet, beispielsweise mittels herkömmlicher Bestückungstechniken bei der Bestückung von Leiterplatten und Substraten. Dabei werden die Metallelemente 60 beispielsweise in einer solchen räumlichen Anordnung zueinander angeordnet, dass in Richtung R der Dicke des Dickschicht-Substrats 20 die gewünschte Strukturierung mittels der jeweiligen Höhe der Metallelemente 60 des Dickschicht-Substrats 20 festgelegt wird.

Das Lot 70 wird beispielsweise derart zwischen die Metallelemente 60 eingebracht, dass die Metallelemente 60 vor ihrer Anordnung bereits mit einer Schicht von Lotmaterial beschichtet sind und die Schichten von Lotmaterial nach der Anordnung der Metallelemente 60 umgeschmolzen werden.

## Patentansprüche

1. Elektronikmodul (10), insbesondere Leistungsmodul, mit einem Schaltungsträger, welcher mindestens eine elektrisch leitende Dickschicht (20) mit mindestens einer Dicke von zumindest 0,5 Millimetern, vorzugsweise mindestens 2 Millimetern und idealerweise mindestens 4 Millimetern, aufweist, welche eine Mehrzahl von miteinander verbundenen, thermisch leitfähigen Elementen (60) aufweist, welche mittels eines thermisch leitfähigen Materials (70), insbesondere stoffschlüssig, miteinander verbunden sind und bei welchem die thermisch leitfähigen Elemente (60) eine Grundfläche (80) mit dreizähliger und/oder vierzähliger und/oder sechszähliger Drehsymmetrie aufweisen.

2. Elektronikmodul nach dem vorhergehenden Anspruch, bei welchem die thermisch leitfähigen Elemente (60) miteinander verbunden sind, indem sie mittels eines Lots (70) und/oder mittels eines Klebers und/oder mittels einer Sinterverbindung miteinander verbunden sind.

3. Elektronikmodul nach einem der vorhergehenden Ansprüche, bei welchem das thermisch leitfähige Material (70) eine Wärmeleitfähigkeit von mindestens 20 mW/mK, vorzugsweise mindestens 30 W/mK, idealerweise zumindest 35 W/mK, aufweist.

4. Elektronikmodul nach einem der vorhergehenden Ansprüche, bei welchem das thermisch leitfähige Material (70) eine Dicke von höchstens 100 Mikrometern, vorzugsweise höchstens 50 Mikrometern, idealerweise höchstens 30 Mikrometern, aufweist.

5. Elektronikmodul nach einem der vorhergehenden Ansprüche, bei welchem die Dickschicht (20) eine Oberfläche aufweist und die thermisch leitfähigen Elemente (60) die Oberfläche nicht plan, vorzugsweise gestuft und/oder strukturiert, bilden.

6. Elektronikmodul nach einem der vorhergehenden Ansprüche, bei welchem die thermisch leitfähigen Elemente (60) mit einem anderen als dem elektrisch leitfähigen Material (70) gebildet sind.

7. Elektronikmodul nach einem der vorhergehenden Ansprüche, bei welchem die thermisch leitfähigen Elemente (60) mit einem Metall, insbesondere Kupfer und/oder Aluminium und/oder Molybdän, und/oder einem Nichtmetall, insbesondere einem elektrisch leitenden Polymer, gebildet sind.

8. Elektronikmodul nach einem der vorhergehenden Ansprüche, bei welchem die thermisch leitfähigen Elemente (60) eine dreieckige und/oder viereckige und/oder sechseckige Grundfläche (80) aufweisen.

9. Verfahren zur Herstellung eines Elektronikmoduls (10) nach einem der vorhergehenden Ansprüche, bei welchem die thermisch leitfähigen Elemente (60) angeordnet und mittels eines thermisch leitfähigen Materials (70) miteinander verbunden werden und bei welchem solche thermisch leitfähigen Elemente (60) herangezogen werden, welche mit dem thermisch leitfähigen Material (70) in Gestalt eines Lots beschichtet sind, wobei die thermisch leitfähigen Elemente (60) angeordnet werden und nachfolgend das thermisch leitfähige Material (70) umgeschmolzen wird.

10. Industrieanlage mit einer Steuereinrichtung (S), insbesondere zur Steuerung eines Motors (M) und/oder Generators vorzugsweise der Industrieanlage (I), welche mindestens ein Elektronikmodul (10) nach einem der vorhergehenden Ansprüche 1 bis 8 umfasst.

## Claims

1. Electronic module (10), in particular a power module, with a circuit carrier which has at least one electrically conductive thick film (20) with at least a thickness of at least 0.5 millimetre, preferably at least 2 millimetres and ideally at least 4 millimetres, which has a plurality of thermally conductive elements (60) connected to one another, which are connected to one another by means of a thermally conductive material (70), in particular by material bonding, and in which the thermally conductive elements (60) have a base area (80) with threefold and/or fourfold and/or sixfold rotational symmetry.

2. Electronic module according to the preceding claim, in which the thermally conductive elements (60) are connected to one another, by being connected to one another by means of a solder (70) and/or by means of an adhesive and/or by means of a sinter connection.

3. Electronic module according to one of the preceding claims, in which the thermally conductive material (70) has a thermal conductivity of at least 20 mW/mK, preferably at least 30 W/mK, ideally at least 35 W/mK.

4. Electronic module according to one of the preceding claims, in which the thermally conductive material (70) has a maximum thickness of 100 micrometres, preferably a maximum of 50 micrometres, ideally a maximum of 30 micrometres.

5. Electronic module according to one of the preceding claims, in which the thick film (20) has a surface and the thermally conductive elements (60) form the surface in a nonplanar manner, preferably in a tiered and/or structured manner.

6. Electronic module according to one of the preceding claims, in which the thermally conductive elements (60) are formed with a material other than the electrically conductive material (70).

7. Electronic module according to one of the preceding claims, in which the thermally conductive elements (60) are formed with a metal, in particular copper and/or aluminium and/or molybdenum, and/or a non-metal, in particular an electrically conductive polymer.

8. Electronic module according to one of the preceding claims, in which the thermally conductive elements (60) have a triangular and/or quadrilateral and/or hexagonal base area (80) .

9. Method for producing an electronic module (10) according to one of the preceding claims, in which the thermally conductive elements (60) are arranged and are connected to one another by means of a thermally conductive material (70) and in which such thermally conductive elements (60) are used, which are coated with the thermally conductive material (70) in the form of a solder, wherein the thermally conductive elements (60) are arranged and then the thermally conductive material (70) is remelted.

10. Industrial plant with a control device (S), in particular for controlling a motor (M) and/or generator preferably of the industrial plant (I), which comprises at least one electronic module (10) as claimed in one of the preceding claims 1 to 8.

## Revendications

1. Module (10) d'électronique,
en particulier module de puissance, comprenant un support de circuit, qui a au moins une couche (20) d'épaisseur conductrice de l'électricité ayant au moins une épaisseur d'au moins 0,5 millimètre, de préférence d'au moins 2 millimètres et idéalement d'au moins 4 millimètres, qui a une pluralité d'éléments (60) reliés entre eux, conducteurs thermiquement, qui sont reliés entre eux au moyen d'un matériau (70) conducteur thermiquement, en particulier à coopération de matière, et dans lequel les éléments (60) conducteurs thermiquement ont une surface (80) de base ayant une symétrie de rotation d'ordre trois et/ou d'ordre quatre et/ou d'ordre six.

2. Module d'électronique suivant la revendication précédente, dans lequel les éléments (60) conducteurs thermiquement sont reliés entre eux par le fait qu'ils sont reliés entre eux au moyen d'une brasure (70) et/ou au moyen d'une colle et/ou au moyen d'une liaison frittée.

3. Module d'électronique suivant l'une des revendications précédentes, dans lequel le matériau (70) conducteur thermiquement a une conductibilité de la chaleur d'au moins 20 mW/mK, de préférence d'au moins 30 W/mK, idéalement d'au moins 35 W/mK.

4. Module d'électronique suivant l'une des revendications précédentes, dans lequel le matériau (70) conducteur thermiquement a une épaisseur de 100 microns au plus, de préférence de 50 microns au plus, idéalement de 30 microns au plus.

5. Module d'électronique suivant l'une des revendications précédentes, dans lequel la couche (20) d'épaisseur a une surface et des éléments (60) conducteurs thermiquement forment la surface non plane, de préférence étagée et/ou structurée.

6. Module d'électronique suivant l'une des revendications précédentes, dans lequel les éléments (60) conducteurs thermiquement sont formés d'un matériau autre que le matériau (70) conducteur de l'électricité.

7. Module d'électronique suivant l'une des revendications précédentes, dans lequel les éléments (60) conducteurs thermiquement sont formés d'un métal, en particulier de cuivre et/ou d'aluminium et/ou de molybdène et/ou d'un non métal, en particulier d'un polymère conducteur de l'électricité.

8. Module d'électronique suivant l'une des revendications précédentes, dans lequel les éléments (60) conducteurs thermiquement ont une surface (80) de base triangulaire et/ou rectangulaire et/ou hexagonale.

9. Procédé de fabrication d'un module (10) électronique suivant l'une des revendications précédentes, dans lequel on dispose les éléments (60) conducteurs thermiquement et on les relie entre eux au moyen d'un matériau (70) conducteur thermiquement, et dans lequel on tire parti d'éléments (60) conducteurs thermiquement, qui sont revêtus du matériau (70) conducteur thermiquement sous la forme d'une brasure, dans lequel on dispose les éléments (60) conducteurs thermiquement et ensuite on refond le matériau (70) conducteur thermiquement.

10. Installation industrielle ayant un dispositif (S) de commande, en particulier de commande d'un moteur (M) et/ou d'un générateur, de préférence d'une installation (I) industrielle, qui comprend au moins un module (10) électronique suivant l'une des revendications 1 à 8 précédentes.
